# EUROPÄISCHE PATENTSCHRIFT

(11) **EP 1 186 087 B1**
(45) Veröffentlichungstag und Bekanntmachung des Hinweises auf die Patenterteilung: **06.06.2007**
(21) Anmeldenummer: 00931284.4
(22) Anmeldetag: 06.06.2000
(51) Int. Cl.: H02J 5/00, G05B 19/042

(54) **SYSTEM FÜR EINE VIELZAHL VON NÄHERUNGSSENSOREN AUFWEISENDE MASCHINE SOWIE NÄHERUNGSSENSOR UND PRIMÄRWICKLUNG HIERZU**
SYSTEM FOR A MACHINE WITH A PLURALITY OF PROXIMITY SENSORS AND A PROXIMITY SENSOR AND A PRIMARY WINDING USED IN SUCH A MACHINE
SYSTEME DESTINE A UNE MACHINE PRESENTANT PLUSIEURS DETECTEURS DE PROXIMITE ET DETECTEURS DE PROXIMITE ET ENROULEMENT DE CIRCUIT PRIMAIRE UTILISES DANS CE SYSTEME

(30) Priorität: 11.06.1999 DE 19926799; 26.06.1999 DE 19929344
(43) Veröffentlichungstag der Anmeldung: 13.03.2002
(73) Patentinhaber: ABB RESEARCH LTD., 8050 Zürich (CH)
(72) Erfinder: SCHEIBLE, Guntram, D-69493 Hirschberg (DE); SMAILUS, Bernd, D-69502 Hemsbach (DE); KLAUS, Martin, D-64625 Bensheim (DE); GARRELS, Kai, D-68239 Mannheim (DE); HEINEMANN, Lothar, D-69493 Hirschberg (DE)
(74) Vertreter: Miller, Toivo
(86) Internationale Anmeldenummer: PCT/EP2000/005137
(87) Internationale Veröffentlichungsnummer: WO 2000/077909

(56) Entgegenhaltungen:
- WO-A-95/11544
- WO-A-98/43338
- DE-C- 19 528 341
- DE-C- 19 735 624
- SCHOENER J ET AL: "DEZENTRALE VERSORGUNG AKTIVER GEBER" RADIO FERNSEHEN ELEKTRONIK,DE,VEB VERLAG TECHNIK. BERLIN, Bd. 41, Nr. 9, 1. September 1992 (1992-09-01), Seiten 627-630, XP000311034 ISSN: 1436-1574
- KAWAMURA A ET AL: "WIRELESS TRANSMISSION OF POWER AND INFORMATION THROUGH ONE HIGH FREQUENCY RESONANT AC LINK INVERTER FOR ROBOT MANIPULATOR APPLICATIONS" RECORD OF THE INDUSTRY APPLICATIONS CONFERENCE (IAS),US,NEW YORK, IEEE, Bd. CONF. 30, 8. Oktober 1995 (1995-10-08), Seiten 2367-2372, XP000547151 ISBN: 0-7803-3009-9

## Beschreibung

Die Erfindung bezieht sich auf ein System für eine eine Vielzahl von Näherungssensoren aufweisende Maschine sowie auf einen Näherungssensor hierzu. Die Erfindung kann zur elektrischen Energieversorgung von an sich bewegenden Maschinenkomponenten (Industrieroboter, Herstellungsautomat, Fertigungsautomat) montierten Näherungssensoren verwendet werden.

Aus Schoener J et al: "Dezentrale Versorgung aktiver Geber" radio fernsehen elektronik, DE, VEB Verlag Technik. Berlin, Bd. 41, Nr. 9, 1. September 1992 (1992-09-01), Seiten 627-630 ist im Zusammenhang mit einem System zur Positionserfassung eine dezentrale Versorgung für eine Vielzahl von Gebern durch induktive Energieübertragung bekannt. Ein an einem Kran installierter Konstantwechselstromgenerator arbeitet mit einer Festfrequenz von 100...130 kHz oder höher auf eine auf Resonanz abgestimmte Rahmenantenne, die eine Wechselstromleistung zu den in den Gebern installierten Kompaktbaugruppen, ebenfalls mit einer auf Resonanz abgestimmten Rahmenantenne ausgerüstet, überträgt. Die induzierte Spannung wird gleichgerichtet und speist die Kompaktbaugruppe. Die zu überbrückende Entfernung beträgt 150 mm. Für eine Kompaktbaugruppe muß eine Leistung von etwa 100 mW übertragen werden.

Aus der DE 44 42 677 A1 sind ein Verfahren und eine Anordnung zum Versorgen eines elektrischen Verbrauchers mit einer elektrischen Versorgungsspannung oder einem elektrischen Versorgungsstrom bekannt, wobei Funkwellen eines Funksenders zu einem mit dem Verbraucher elektrisch verbundenen Funkempfänger übertragen werden und vom Funkempfänger in die elektrische Versorgungsspannung bzw. den elektrischen Versorgungsstrom umgewandelt werden. Die Funkwellen können aus dem elektromagnetischen Hochfrequenzbereich (Radiowellen) oder auch aus dem Mikrowellenbereich (Richtfunk) kommen. Als elektrische Verbraucher können Sensoren, beispielsweise Strom- oder Spannungssensoren vorgesehen sein.

Dabei ist es von Nachteil, daß aufgrund der hohen Frequenzen und dementsprechend kleinen Antennen einerseits und der durch EMV-Vorschriften und Regeln für Sicherheit und Gesundheitsschutz an Arbeitsplätzen mit Exposition durch elektrische, magnetische oder elektromagnetische Felder beschränkten zulässigen Sendeleistung andererseits nur sehr unzureichend geringe Abstände zwischen Funksender und Funkempfänger erzielbar sind. Das gleiche trifft für die erzielbaren Leistungen zu, welche im Bereich weniger µW liegen.

Der Erfindung liegt die Aufgabe zugrunde, ein kostengünstiges und zuverlässiges System für eine eine Vielzahl von Näherungssensoren aufweisende Maschine anzugeben, welches eine drahtlose Versorgung der Näherungssensoren mit elektrischer Energie sicherstellt.

Ferner soll ein hierzu geeigneter Näherungssensor vorgeschlagen werden.

Die Aufgabe wird bezüglich des Systems durch ein System für eine eine Vielzahl von Näherungssensoren aufweisende Maschine, insbesondere Fertigungsautomat, gelöst, wobei jeder Näherungssensor mindestens eine zur Energieaufnahme aus einem mittelfrequenten Magnetfeld geeignete Sekundärwicklung aufweist, wobei mindestens eine von einem mittelfrequenten Oszillator gespeiste Primärwicklung zur drahtlosen Versorgung der Näherungssensoren mit elektrischer Energie vorgesehen ist und wobei jeder Näherungssensor mit einer Sendeeinrichtung ausgestattet ist, welche interessierende Sensor-Informationen beinhaltende Funksignale an eine zentrale, mit einem Prozeßrechner der Maschine verbundene Empfangseinrichtung abgibt.

Die Aufgabe wird bezüglich des Näherungssensors durch einen Näherungssensor mit mehreren zur Energieaufnahme aus einem mittelfrequenten Magnetfeld geeigneten Sekundärwicklungen gelöst. Unter den in diesem Zusammenhang interessierenden mittelfrequenten Schwingungen wird der Bereich von etwa 15 kHz bis etwa 15 MHz verstanden.

Die mit der Erfindung erzielbaren Vorteile bestehen insbesondere darin, daß im Vergleich zu konventionellen Lösungen mit Kabelanschluß zur elektrischen Energieversorgung der Näherungssensoren der durch Planung, Material, Installation, Dokumentation und Wartung bedingte relativ hohe Kostenfaktor eines Kabelanschlusses entfällt. Es können keine Ausfälle aufgrund von Kabelbrüchen oder schlechten, beispielsweise korrodierten Kontakten auftreten.

Im Vergleich zur Verwendung von Batterien zur Energieversorgung von Näherungssensoren entfällt der Wartungsaufwand und Kostenaufwand, der durch den erforderlichen Austausch von Batterien - zumal an schwer zugänglichen Stellen - bedingt ist.

Im angegebenen Mittelfrequenz-Bereich von etwa 15 kHz bis etwa 15 MHz sind die sich durch Skineffekte ergebenden Nachteile, beispielsweise die auftretenden Verluste, noch handhabbar. Die elektromagnetischen Wellen werden aufgrund der im Vergleich zu den auftretenden Wellenlängen zu kleinen und deshalb als Antennen unwirksamen Primärwicklungen nicht abgestrahlt, wodurch ein einfacher Aufbau der Anordnungen ermöglicht wird. Eine EMV-Messung von eventuell abgestrahlten Störungen muß nicht erfolgen. Günstig wirkt sich zudem aus, daß mittelfrequente Magnetfelder durch metallische Maschinen-Komponenten nur in geringem Ausmaß abgeschirmt werden, so daß vorteilhaft auch an unzugänglichen Stellen einer Maschine ein zur Energieversorgung ausreichend starkes Magnetfeld auftritt.

Weitere Vorteile sind aus der nachstehenden Beschreibung ersichtlich.

Vorteilhafte Ausgestaltungen der Erfindung sind in den Unteransprüchen gekennzeichnet.

Die Erfindung wird nachstehend anhand der in der Zeichnung dargestellten Ausführungsbeispiele erläutert. Es zeigen:
- Fig.1: ein Prinzipschaltbild der Anordnung zur drahtlosen elektrischen Versorgung von Näherungssensoren,
- Fig. 2: ein Schaltbild zur Erläuterung des verwendeten Transformatorprinzips,
- Fig. 3: eine erste praktische Ausführungsform,
- Fig. 4: eine zweite praktische Ausführungsform,
- Fig. 5: eine dritte Ausführungsform mit orthogonalen Primärwicklungen,
- Fig. 6: eine vierte Ausführungsform mit unterschiedlich gestalteten Primärwicklungen,
- Fig. 7: eine fünfte Ausführungsform mit bandförmiger Primärwicklung,
- Fig. 8: ein Ersatzschaltbild mit primärseitigen und sekundärseitigen Weiterbildungen,

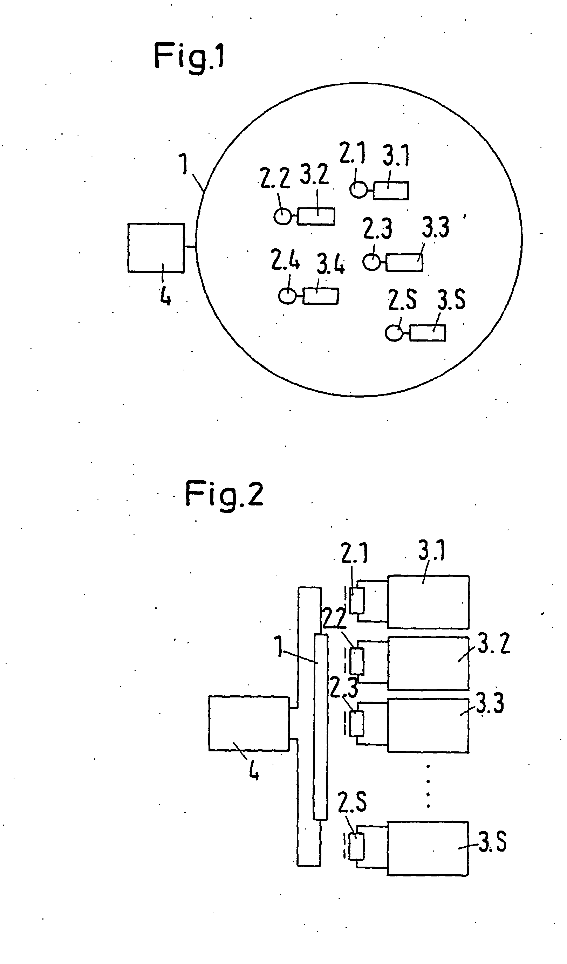

In Fig. 1 ist ein Prinzipschaltbild der Anordnung zur drahtlosen elektrischen Versorgung von Näherungssensoren dargestellt. Es ist eine kreisförmige, vorzugsweise aus mehreren Windungen aufgebaute Primärwicklung 1 zu erkennen, welche eine Vielzahl - gegebenenfalls bis zu einigen Hundert - von Sekundärwicklungen 2.1, 2.2, 2.3....2.s (s = beliebige ganze Zahl) umfaßt, wobei jede Sekundärwicklung 2.1 bzw. 2.2 bzw. 2.3....2.s mit einem Näherungssensor 3.1 bzw. 3.2 bzw. 3.3....3.s verbunden ist. Die Primärwicklung 1 ist an einen Oszillator 4 (Mittelfrequenz-Oszillator) angeschlossen. Der Oszillator 4 speist die Primärwicklung 1 mit einer mittelfrequenten Schwingung im Bereich von etwa 15 kHz bis etwa 15 MHz. Diese Mittelfrequenz würde zur Abstrahlung von elektromagnetischen Feldern führen, deren Wellenlängen größer als 22 m bis 22 km sind und damit wesentlich größer als die Abmessungen der eingesetzten Primärwicklung - kleiner als 2 m - , so daß die Primärwicklung nicht als Antenne für derartige elektromagnetische Strahlung wirkt. Es liegt also eine rein magnetische Kopplung (und keine wirksame elektromagnetische Kopplung) zwischen der Primärwicklung und den Sekundärwicklungen im Sinne eines Mittelfrequenz-Transformators vor.

Die Leistungsaufnahme eines Näherungssensors liegt im Bereich einiger zehn µW bis etwa 50 mW, vorzugsweise bei 1 mW.

In Fig. 2 ist ein Schaltbild zur Erläuterung des verwendeten Transformatorprinzips dargestellt. Es sind wiederum die Primärwicklung 1 mit einspeisendem Oszillator 4 und die Näherungssensoren 3.1....3.s mit den angeschlossenen Sekundärwicklungen 2.1....2.s zu erkennen.

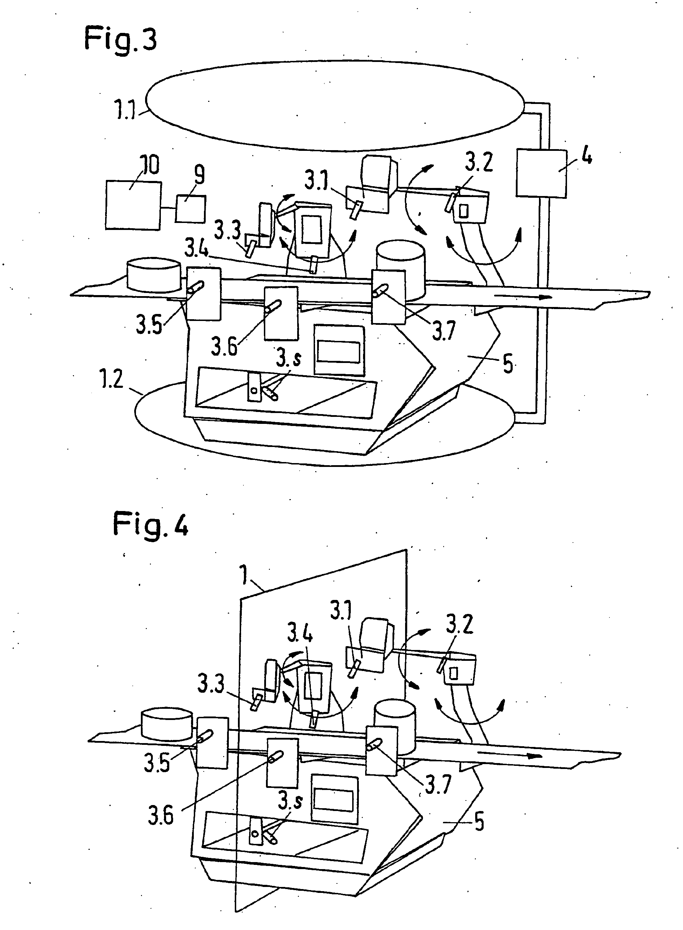

In Fig. 3 ist eine erste praktische Ausführungsform dargestellt. Es ist eine Maschine 5 - insbesondere ein Industrieroboter bzw. Herstellungsautomat bzw. Fertigungsautomat - gezeigt, welche mit zahlreichen an beweglichen Maschinenkomponenten montierten Näherungssensoren 3.1....3.s versehen ist. Die Maschine 5 befindet sich zwischen zwei horizontal angeordneten Primärwicklungen 1.1 und 1.2. Diese beiden Primärwicklungen 1.1, 1.2 liegen elektrisch parallel am Oszillator 4 (Generator) oder werden alternativ von zwei separaten Oszillatoren gespeist. Zwischen beiden Primärwicklungen tritt ein relativ gleichmäßiges Magnetfeld auf. Von Wichtigkeit ist es dabei, daß sich die Näherungssensoren stets im sich zwischen beiden Primärwicklungen 1.1, 1.2 ausbildenden magnetischen Feld befinden, so daß über ihre Sekundärwicklungen eine magnetische Ankopplung wirksam und demzufolge eine Energieeinspeisung möglich ist.

Jeder Näherungssensor ist mit einer Sendeeinrichtung ausgestattet, die Funksignale hinsichtlich der erfaßten interessierenden Sensor-Information, insbesondere des Näherungszustandes "zu detektierendes Objekt vorhanden/nicht vorhanden" abgibt. Die Funksignale aller Näherungssensoren werden von einer zentralen Empfangseinrichtung 9 empfangen und an einen Prozeßrechner 10 (speicherprogrammierbare Steuerung) weitergeleitet. Vorzugsweise befindet sich die Empfangseinrichtung in unmittelbarer Nähe der Maschine 5, um eine optimale Funkverbindung mit den Näherungssensoren zu gewährleisten, während der die Maschine steuernde Prozeßrechner 10 auch entfernt von der Maschine 5 angeordnet sein kann. Wie leicht erkennbar ist, ergibt sich durch das vorgeschlagene System eine kabellose Konfiguration der Näherungssensoren sowohl hinsichtlich ihrer elektrischen Energieversorgung als auch hinsichtlich der Informationsübertragung zum Prozeßrechner.

In Erweiterung des vorgeschlagenen Systems sind die Näherungssensoren mit Empfangseinrichtungen versehen, die Funksignale einer zentralen Sendeeinrichtung empfangen. Auf diese Weise ist ein bidirektionaler Informationsaustausch zwischen dem Prozeßrechner und den Näherungssensoren möglich, wobei jeweils Sende/Empfangseinrichtungen für die Funksignale vorzusehen sind.

In Fig. 4 ist eine zweite praktische Ausführungsform dargestellt. Bei dieser Ausführungsform ist lediglich eine einzige Primärwicklung 1 vorgesehen, welche die Maschine 5 - insbesondere ein Industrieroboter bzw. Herstellungsautomat bzw. Fertigungsautomat- mit den zahlreichen, an ihr montierten Näherungssensoren 3.1....3.s global umfaßt.

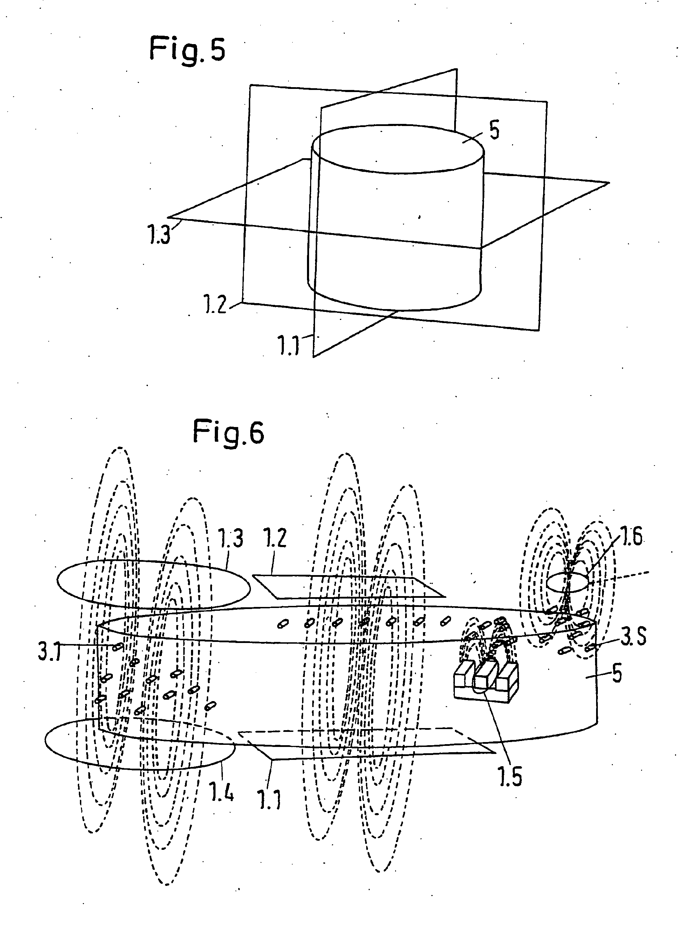

In Fig. 5 ist eine dritte Ausführungsform mit drei orthogonal zueinander angeordneten Primärwicklungen dargestellt. Es ist eine Maschine 5 gezeigt, welche von einer ersten vertikalen Primärwicklung 1.1, einer hierzu orthogonalen zweiten vertikalen Primärwicklung 1.2 und einer horizontalen dritten Primärwicklung 1.2 umschlossen ist. Bei dieser Ausführungsform mit drei orthogonalen Primärwicklungen ergibt sich eine besonders gleichmäßige und nicht gerichtete Ausbildung des magnetischen Feldes. Alternativ bzw. ergänzend hierzu ist es auch möglich, jeden Näherungssensor mit zwei oder drei orthogonalen Sekundärwicklungen auszurüsten.

Des weiteren ist auch eine Ausführungsform realisierbar, bei der lediglich zwei orthogonale Primärwicklungen vorgesehen sind. Selbstverständlich sind auch Ausführungsformen realisierbar, welche mehrere Primärwicklungen 1.1 bis 1.p aufweisen, die nicht orthogonal angeordnet sind.

In Fig. 6 ist eine vierte Ausführungsform mit mehreren unterschiedlich gestalteten Primärwicklungen dargestellt. Es handelt sich um eine relativ ausgedehnte Maschine 5, bei der die einzelnen Näherungssensoren 3.1....3.s nicht einigermaßen homogen über die Maschine verteilt angeordnet sind, sondern lediglich an einigen bestimmten Bereichen der Maschine gehäuft auftreten. Bei einer derartigen ausgedehnten Konfiguration ist aus Gründen der zu erzielenden magnetischen Feldstärke der Einsatz mehrerer, gezielt angeordneter Primärwicklungen vorteilhaft, welche jeweils mindestens eine Sekundärwicklung eines Näherungssensors lokal beeinflussen.

Ein erster mit Näherungssensoren bestückter Maschinenbereich liegt dabei im Magnetfeld zwischen zwei horizontalen, rechteckförmigen, sich einander gegenüberliegenden Primärwicklungen 1.1, 1.2. Ein zweiter, hierzu benachbarter, mit Näherungssensoren bestückter Maschinenbereich liegt im Magnetfeld zwischen zwei horizontalen, kreisringförmigen oder ovalen, sich einander gegenüberliegender Primärwicklungen 1.3, 1.4. Ein dritter mit Näherungssensoren bestückter Maschinenbereich wird vom Magnetfeld einer Primärwicklung 1.5 beeinflußt, wobei diese Primärwicklung um den Mittelschenkel eines E-förmigen Ferritkemes angeordnet ist, wodurch sich teilweise eine Abschirmung des Magnetfeldes und sich teilweise eine Verstärkung im interessierenden, lokal begrenzten Bereich ergibt ("Spot-Wirkung"). Ein vierter mit Näherungssensoren bestückter Maschinenbereich liegt im Einflußbereich einer Primärwicklung 1.6. Die Magnetfelder der einzelnen Primärwicklungen 1.1 bis 1.6 in den einzelnen Maschinenbereichen sind jeweils gestrichelt angedeutet.

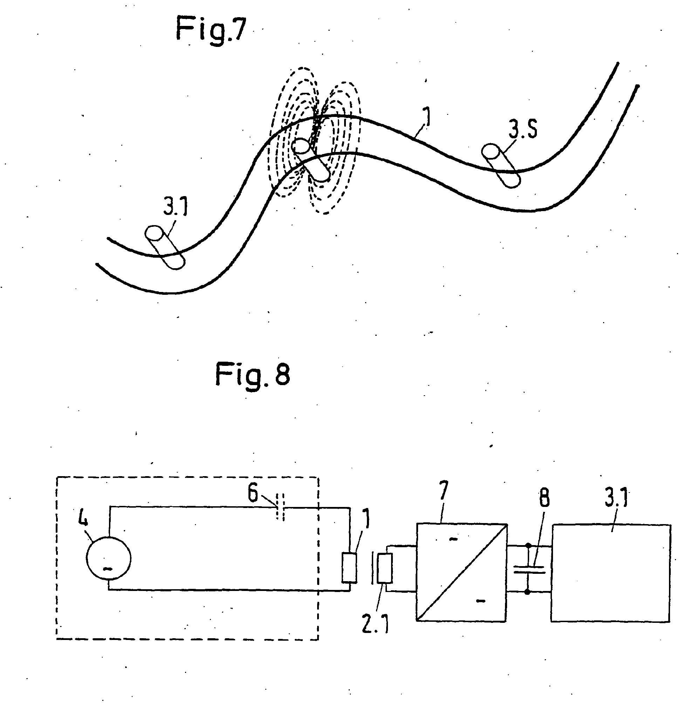

In Fig. 7 ist eine fünfte Ausführungsform mit bandförmiger Primärwicklung dargestellt. Die bandförmige Primärwicklung 1 ist an ihrem einen Ende am Oszillator 4 angeschlossen, während das weitere Ende zusammengeschaltet ist. Auf diese Weise ergibt sich eine Doppelleitung mit zwei vom gleichen Strom mit entgegengesetzter Richtung durchflossenen Leitern, was das Magnetfeld zwischen beiden Leitern in gewünschter Weise verstärkt und das Magnetfeld im Bereich außerhalb der beiden Leiter abschwächt. Vorteilhaft wird die bandförmige Primärwicklung 1 an der Maschine derart installiert, daß sich die einzelnen Näherungssensoren 3.1 bis 3.n im Bereich zwischen beiden Leitern der Doppelleitung befinden.

Selbstverständlich kann dabei jede Leitung der Doppelleitung aus mehreren Einzelleitern bestehen, wobei die Einzelleiter beider Leitungen im Sinne einer Wicklung miteinander verbunden sind, so daß sich quasi eine Primärwicklung 1 wie unter Fig. 4 beschrieben ergibt, welche extrem flach ausgebildet ist.

In Fig. 8 ist ein Ersatzschaltbild mit primärseitigen und sekundärseitigen Weiterbildungen dargestellt. Wie zu erkennen ist, liegt die Primärwicklung 1 über einem Kompensationskondensator 6 am Oszillator 4, wodurch ein resonanter Betrieb des Oszillators erzielt wird. Lediglich beispielhaft ist die magnetische Kopplung zwischen Primärwicklung 1 und Sekundärwicklung 2.1 angedeutet. An die Sekundärwicklung 2.1 ist ein AC/DC-Steller 7 angeschlossen, der einen zur Energieversorgung des Sensors 3.1 dienenden Energiespeicher 8 speist.

In Erweiterung des in Fig. 8 dargestellten Schaltbildes ist es auch möglich, einen Kompensationskondensator in der Anschlußleitung zwischen Sekundärwicklung 2.1 und AC/DC-Steller 7 vorzusehen.

## Patentansprüche

1. System für eine eine Vielzahl von Näherungssensoren aufweisende Maschine, insbesondere Fertigungsautomat,
- wobei jeder Näherungssensor (3.1 bis 3.s) mindestens eine zur Energieaufnahme aus einem mittelfrequenten Magnetfeld geeignete Sekundärwicklung (2.1 bis 2.s) aufweist,
- wobei mindestens eine von einem mittelfrequenten Oszillator (4) gespeiste Primärwicklung (1, 1.1 bis 1.p) zur drahtlosen Versorgung der Näherungssensoren (3.1 bis 3.s) mit elektrischer Energie vorgesehen ist,
- wobei jeder Näherungssensor (3.1 bis 3.s) mit einer Sendeeinrichtung ausgestattet ist, welche interessierende Sensor-Informationen beinhaltende Funksignale an eine zentrale, mit einem Prozeßrechner (10) der Maschine verbundene Empfangseinrichtung (9) abgibt.

2. System nach Anspruch 1, **gekennzeichnet durch** eine einzige, die Sekundärwicklungen (2.1 bis 2.s) der Näherungssensoren (3.1 bis 3.s) global umfassende Primärwicklung (1).

3. System nach Anspruch 1, **gekennzeichnet durch** mindestens zwei parallel nebeneinander angeordnete Primärwicklungen (1.1, 1.2), zwischen denen die Sekundärwicklungen (2.1 bis 2.s) der Näherungssensoren (3.1 bis 3.s) angeordnet sind.

4. System nach Anspruch 1, **gekennzeichnet durch** zwei orthogonal zueinander angeordnete Primärwicklungen (1.1, 1.2).

5. System nach Anspruch 1, **gekennzeichnet durch** drei orthogonal zueinander angeordnete Primärwicklungen (1.1, 1.2, 1.3).

6. System nach Anspruch 1, **gekennzeichnet durch** mindestens eine, mindestens eine Sekundärwicklung (2.1 bis 2.s) eines Näherungssensors (3.1 bis 3.s) lokal beeinflussende Primärwicklung (1.1 bis 1.p).

7. System nach Anspruch 1, **gekennzeichnet durch** eine in Form einer Doppelleitung ausgeführte Primärwicklung (1), wobei die Sekundärwicklungen (2.1 bis 2.s) der Näherungssensoren (3.1 bis 3.s) zwischen der Doppelleitung angeordnet sind.

8. System nach einem der vorstehenden Ansprüche, **dadurch gekennzeichnet, daß** mindestens eine Primärwicklung mit einem Ferritkern versehen ist.

9. System nach einem der vorstehenden Ansprüche, **dadurch gekennzeichnet, daß** die mindestens eine Primärwicklung mit einem Kompensationskondensator (6) beschaltet ist.

10. System nach mindestens einem der vorstehenden Ansprüche, **dadurch gekennzeichnet, daß** die Näherungssensoren (3.1 bis 3.s) mit Empfangseinrichtungen versehen sind, welche Funksignale einer zentralen Sendeeinrichtung empfangen, so daß ein bidirektionaler Informationsaustausch zwischen dem Prozeßrechner (10) und den Näherungssensoren (3.1 bis 3.s) möglich ist.

11. Näherungssensor mit mehreren zur Energieaufnahme aus einem mittelfrequenten Magnetfeld geeigneten orthogonalen Sekundärwicklungen (2.1 bis 2.s).

12. Näherungssensor nach Anspruch 11, **dadurch gekennzeichnet, daß** die Sekundärwicklungen (2.1 bis 2.s) mit einem Kompensationskondensator (6) beschaltet sind.

13. Näherungssensor nach Anspruch 11 oder 12, **dadurch gekennzeichnet, daß** die Sekundärwicklungen (2.1 bis 2.s) mit einem AC/DC-Steller beschaltet sind, welcher einen Energiespeicher (8) auflädt.

## Claims

1. System for a machine comprising a large number of proximity sensors, in particular an automated production machine, wherein each proximity sensor (3.1 to 3.s) comprises at least one secondary winding (2.1 to 2.s) capable of drawing power from a medium-frequency magnetic field, wherein at least one primary winding (1, 1.1 to 1.p) fed by a medium-frequency oscillator (4) is provided for wirelessly supplying the proximity sensors (3.1 to 3.s) with electrical power, wherein each proximity sensor (3.1 to 3.s) is provided with a transmitting device which emits radio signals containing interesting sensor information to a central receiving device (9) connected to a process computer (10) of the machine.

2. System according to claim 1, **characterised by** a single primary winding (10) globally incorporating the secondary winding (2.1 to 2.s) of the proximity sensors (3.1 to 3.s).

3. System according to claim 1, **characterised by** at least two parallel primary windings (1.1, 1.2) arranged side by side and between which the secondary windings (2.1 to 2.s) of the proximity sensors (3.1 to 3.s) are arranged.

4. System according to claim 1, **characterised by** two primary windings (1.1, 1.2) arranged orthogonally to each other.

5. System according to claim 1, **characterised by** three primary windings (1.1, 1.2, 1.3) arranged orthogonally to each other.

6. System according to claim 1, **characterised by** at least one primary winding (1.1 to 1.p) locally affecting at least one secondary winding (2.1, to 2.s) of a proximity sensor (3.1 to 3.s).

7. System according to claim 1, **characterised by** a primary winding (1) constructed in the form of a double line, the secondary windings (2.1 to 2.s) of the proximity sensors (3.1 to 3.s) being arranged between the double line.

8. System according to any one of the preceding claims, **characterised in that** at least one primary winding is provided with a ferrite core.

9. System according to any one of the preceding claims, **characterised in that** the at least one primary winding is wired with a compensation capacitor (6).

10. System according to at least one of the preceding claims, **characterised in that** the proximity sensors (3.1 to 3.s) are provided with receiving devices which receive radio signals from a central transmitting device, so a bidirectional exchange of information is possible between the process computer (10) and the proximity sensors (3.1 to 3.s).

11. Proximity sensor comprising a plurality of orthogonal secondary windings (2.1 to 2.s) capable of drawing power from a medium-frequency magnetic field.

12. Proximity sensor according to claim 11, **characterised in that** the secondary windings (2.1 to 2.s) are wired with a compensation capacitor (6).

13. Proximity sensor according to claim 11 or 12, **characterised in that** the secondary windings (2.1 to 2.s) are wired with an AC/DC actuator which charges an energy store.

## Revendications

1. Système destiné à une machine présentant une pluralité de détecteurs de proximité, plus particulièrement à un automate de fabrication, où
- chaque détecteur de proximité (3.1 à 3.s) comprend au moins un enroulement secondaire (2.1 à 2.s) adapté pour l'absorption d'énergie à partir d'un champ magnétique à moyenne fréquence,
- il est prévu au moins un enroulement primaire (1, 1.1 à 1.p) alimenté par un oscillateur (4) à moyenne fréquence et destiné à l'alimentation sans fil des détecteurs de proximité (3.1 à 3.s) avec de l'énergie électrique,
- chaque détecteur de proximité (3.1 à 3.s) est équipé d'un dispositif émetteur qui transmet des signaux radio, contenant des informations de détecteurs à traiter, à un dispositif récepteur (9) central connecté à un ordinateur industriel (10) de la machine.

2. Système selon la revendication 1, **caractérisé en ce qu'**il comprend un enroulement primaire (1) unique, englobant les enroulements secondaires (2.1 à 2.s) des détecteurs de proximité (3.1 à 3.s).

3. Système selon la revendication 1, **caractérisé en ce qu'**il comprend au moins deux enroulements primaires (1.1, 1.2) disposés parallèlement l'un à côté de l'autre, entre lesquels sont placés les enroulements secondaires (2.1 à 2.s) des détecteurs de proximité (3.1 à 3.s).

4. Système selon la revendication 1, **caractérisé en ce qu'**il comprend deux enroulements primaires (1.1, 1.2) disposés de façon orthogonale l'un par rapport à l'autre.

5. Système selon la revendication 1, **caractérisé en ce qu'**il comprend trois enroulements primaires (1.1, 1.2, 1.3) disposés de façon orthogonale les uns par rapport aux autres.

6. Système selon la revendication 1, **caractérisé en ce qu'**il comprend au moins un enroulement primaire (1.1 à 1.p) agissant localement sur au moins un enroulement secondaire (2.1 à 2.s) d'un détecteur de proximité (3.1 à 3.s).

7. Système selon la revendication 1, **caractérisé en ce qu'**il comprend un enroulement primaire (1) réalisé sous la forme d'une ligne à deux conducteurs, les enroulements secondaires (2.1 à 2.s) des détecteurs de proximité (3.1 à 3.s) étant disposés entre les deux conducteurs de la ligne.

8. Système selon une des revendications précédentes, **caractérisé en ce qu'**au moins un enroulement primaire est pourvu d'un noyau de ferrite.

9. Système selon une des revendications précédentes, **caractérisé en ce que** l'enroulement primaire, au nombre d'au moins un, est connecté à un condensateur de compensation (6).

10. Système selon au moins une des revendications précédentes, **caractérisé en ce que** les détecteurs de proximité (3.1 à 3.s) sont dotés de dispositifs récepteurs qui reçoivent des signaux radio d'un dispositif émetteur central, de sorte qu'il est possible de réaliser un échange d'informations bidirectionnel entre l'ordinateur industriel (10) et les détecteurs de proximité (3.1 à 3.s).

11. Détecteur de proximité, comprenant plusieurs enroulements secondaires (2.1 à 2.s) orthogonaux, adaptés à une absorption d'énergie à partir d'un champ magnétique à moyenne fréquence.

12. Détecteur de proximité selon la revendication 11, **caractérisé en ce que** les enroulements secondaires (2.1 à 2.s) sont connectés à un condensateur de compensation (6).

13. Détecteur de proximité selon la revendication 11 ou 12, **caractérisé en ce que** les enroulements secondaires (2.1 à 2.s) sont connectés à un actionneur AC/CC qui charge un accumulateur d'énergie (8).
